# EUROPÄISCHE PATENTSCHRIFT

(11) **EP 2 880 205 B1**
(45) Veröffentlichungstag und Bekanntmachung des Hinweises auf die Patenterteilung: **05.10.2016**
(21) Anmeldenummer: 13734717.5
(22) Anmeldetag: 01.07.2013
(51) Int. Cl.: C30B 13/20, C30B 13/30, C30B 13/16

(54) **VORRICHTUNG ZUR HERSTELLUNG EINES EINKRISTALLS DURCH KRISTALLISIEREN DES EINKRISTALLS AN EINER SCHMELZENZONE**
DEVICE FOR PRODUCING A MONOCRYSTAL BY CRYSTALLIZING SAID MONOCRYSTAL IN A MELTING AREA
DISPOSITIF DE FABRICATION D'UN MONOCRISTAL PAR CRISTALLISATION DUDIT MONOCRISTAL AU NIVEAU D'UNE ZONE DE FUSION

(30) Priorität: 02.08.2012 DE 102012213715
(43) Veröffentlichungstag der Anmeldung: 10.06.2015
(73) Patentinhaber: Siltronic AG, 81737 München (DE)
(72) Erfinder: RAMING, Georg, 84367 Tann (DE); ALTMANNSHOFER, Ludwig, 83661 Lenggries (DE)
(86) Internationale Anmeldenummer: PCT/EP2013/063825
(87) Internationale Veröffentlichungsnummer: WO 2014/019788

(56) Entgegenhaltungen:
- EP-A1- 0 629 719
- WO-A2-2008/025872
- CN-A- 102 321 913
- JP-A- 2008 222 481

## Beschreibung

Gegenstand der Erfindung ist eine Vorrichtung zur Herstellung eines Einkristalls durch Kristallisieren des Einkristalls an einer Schmelzenzone. Die Vorrichtung eignet sich insbesondere zur Herstellung eines Einkristalls aus Silizium.

Die DE 30 07 377 A1 beschreibt eine bekannte Ausführungsform einer solchen Vorrichtung und ein Verfahren, das Zonenschmelz-Verfahren oder FZ-Verfahren genannt wird. Diese Ausführungsform umfasst ein Gehäuse, in der eine Ziehwelle und ein Induktor untergebracht sind. Am oberen Ende der Ziehwelle befindet sich ein Keimkristall, auf dem geschmolzenes Silizium zunächst zu einem Abschnitt mit verengtem Durchmesser und anschließend zu einem Einkristall kristallisiert. Der Induktor, eine als Flachspule ausgebildete HF-Induktionsheizspule, bringt polykristallines Silizium am unteren Ende eines Stabes zum Schmelzen und erzeugt und stabilisiert eine Schmelzenzone, die das Material liefert, welches der Einkristall zum Wachsen benötigt. Der polykristalline Stab und der Einkristall werden abgesenkt, um ein kontinuierliches Wachsen des Einkristalls zu ermöglichen.

Eine Abwandlung des FZ-Verfahrens ("floating zone") ist das GFZ-Verfahren ("granular floating zone"), das beispielsweise in der US 2011/0095018 A1 beschrieben ist. Beim GFZ-Verfahren wird an Stelle eines Stabs als Rohmaterial polykristallines Granulat verwendet. Darüber hinaus sind zwei Induktionsheizspulen vorhanden, eine erste zum Schmelzen des Granulats und eine zweite zum Stabilisieren der Schmelzenzone durch Erzeugen von Wärme in der Schmelzenzone.

Das Temperaturfeld in der Schmelzenzone und im abkühlenden Einkristall, insbesondere im Bereich der Kristallisationsgrenze muss möglichst präzise kontrolliert werden. Insbesondere muss steilen Temperaturgradienten entgegengewirkt werden, die thermische Spannungen verursachen und Ursache von Versetzungsbildung bis hin zur Zerstörung des Einkristalls durch Rissbildung sein können. Es hat sich als vorteilhaft erwiesen, zur Kontrolle des Temperaturfelds einen Reflektor vorzusehen, der den wachsenden Einkristall umgibt und Wärmestrahlung auf diesen reflektiert.

In der CN 102321913 A wird zusätzlich zur Verwendung eines Reflektors vorgeschlagen, ein transversales Magnetfeld einzusetzen, um Fluktuationen der Temperatur in der Schmelzenzone zu unterdrücken.

In EP 0 629 719 A1 ist eine Vorrichtung zur Herstellung eines Einkristalls nach dem FZ-Verfahren beschrieben, die ebenfalls einen Reflektor und eine Spule zum Beaufschlagen der Schmelzenzone mit einem Magnetfeld umfasst.

Es ist Aufgabe der vorliegenden Erfindung, eine Störung des Temperaturfelds insbesondere im Bereich der Kristallisationsgrenze zu vermeiden, die weder durch den Einsatz eines Reflektors noch durch das Erzeugen eines Magnetfelds beseitigt werden kann.

Gelöst wird die Aufgabe durch eine Vorrichtung zur Herstellung eines Einkristalls (1) durch Kristallisieren des Einkristalls (1) an einer Schmelzenzone (2), umfassend ein Gehäuse, einen Induktor (3) zum Erzeugen von Wärme in der Schmelzenzone (2), einen Nachheizer (4), der den unter der Schmelzenzone (2) kristallisierenden Einkristall (1) umgibt und mit Wärmestrahlung beaufschlagt, und einen Trennboden (6), der einen Zwischenraum zwischen dem Nachheizer (4) und einer Wand (5) des Gehäuses an einem unteren Ende des Nachheizers (4) nach unten hin begrenzt und strömendem Schutzgas als Barriere im Weg steht.

Der Nachheizer ist vorzugsweise ein Reflektor oder eine aktive Strahlungsheizung, beispielsweise ein Widerstandsheizer.

Ursache der Störung des Temperaturfelds ist thermischer Auftrieb von Schutzgas, beispielsweise Argon, im Gehäuse, wodurch dem kristallisierenden Einkristall und der Schmelzenzone unkontrolliert Wärme entzogen wird. Übliche Maßnahmen wie das Beaufschlagen des Gehäuses mit Überdruck an Schutzgas zur Vermeidung von Sekundärreaktionen und zur Verhinderung von elektrischen Überschlägen am Induktor oder an dessen Stromzuführungen und das Anordnen eines Reflektors um den kristallisierenden Einkristall begünstigen das Entstehen von Konvektion, die durch thermischen Auftrieb von Schutzgas angeregt wird. So wirkt der Zwischenraum zwischen dem kristallisierenden Einkristall und dem Reflektor wie ein Abzug, der den thermischen Auftrieb von Schutzgas begünstigt.

Ziel der vorliegenden Erfindung ist es, störenden thermischen Auftrieb von Schutzgas weitgehend zu unterbinden. Erreicht wird dieses Ziel durch einen Trennboden, der dem strömenden Schutzgas als Barriere im Weg steht. Der Trennboden ist derart im Gehäuse angeordnet, dass durch ihn ein Zwischenraum zwischen dem Nachheizer und einer Wand des Gehäuses an einem unteren Ende des Nachheizers nach unten hin begrenzt wird.

Darüber hinaus ist es bevorzugt, Spalte, die zwischen dem Nachheizer und dem Trennboden und zwischen der Wand des Gehäuses und dem Trennboden vorhanden sein können, mittels Sperren zu verkürzen oder zu schließen, um den thermischen Auftrieb des Schutzgases noch stärker zu behindern oder vollständig zu blockieren. Als Sperren eignen sich beispielsweise Ringe aus Metall wie beispielsweise Stahl, Silber oder Quarzglas, die die Spalte überdecken. Der Spalt zwischen der Wand des Gehäuses und dem Trennboden wird vorzugsweise mit einem Ring aus Stahl, der Spalt zwischen dem Nachheizer und dem Trennboden vorzugsweise mit einem Ring aus Silber oder Quarzglas überdeckt.

Die Anordnung des Trennbodens verhindert, dass Schutzgas der Schmelzenzone und dem kristallisierenden Einkristall Wärme unkontrolliert entzieht, und damit auch Folgeschäden, die wegen der damit bewirkten Störung des Temperaturfelds eintreten können. Darüber hinaus hat der ausbleibende Wärmeentzug weitere Vorteile. Die Heizleistung des Induktors kann reduziert werden, was Ereignisse wie elektrische Überschläge am Induktor oder an dessen Stromzuführungen weniger wahrscheinlich macht und thermische Spannungen im kristallisierenden Einkristall reduziert.

Der obere Rand des Nachheizers befindet sich vorzugsweise auf Höhe des Tripelpunkts der Kristallisationsgrenze. Der Nachheizer hat eine axiale Länge, die vorzugsweise nicht länger ist als das 1,5-Fache des Durchmessers des herzustellenden Einkristalls. Der radiale Abstand zwischen dem Einkristall und dem Nachheizer beträgt vorzugsweise nicht mehr als 30 mm, besonders bevorzugt ist ein radialer Abstand von 10 mm bis 20 mm.

Die Erfindung wird vorzugsweise zur Herstellung von Einkristallen aus Silizium mit einem vergleichsweise großen Durchmesser von mindestens 150 mm verwendet. Als Herstellungsverfahren kommen sowohl das FZ-Verfahren als auch das GFZ-Verfahren in Betracht.

Die Erfindung wird nachfolgend an Hand von Zeichnungen näher erläutert.
Fig.1 ist eine schematische Darstellung, die den Stand der Technik repräsentiert.
Fig.2 ist eine schematische Darstellung der Erfindung.

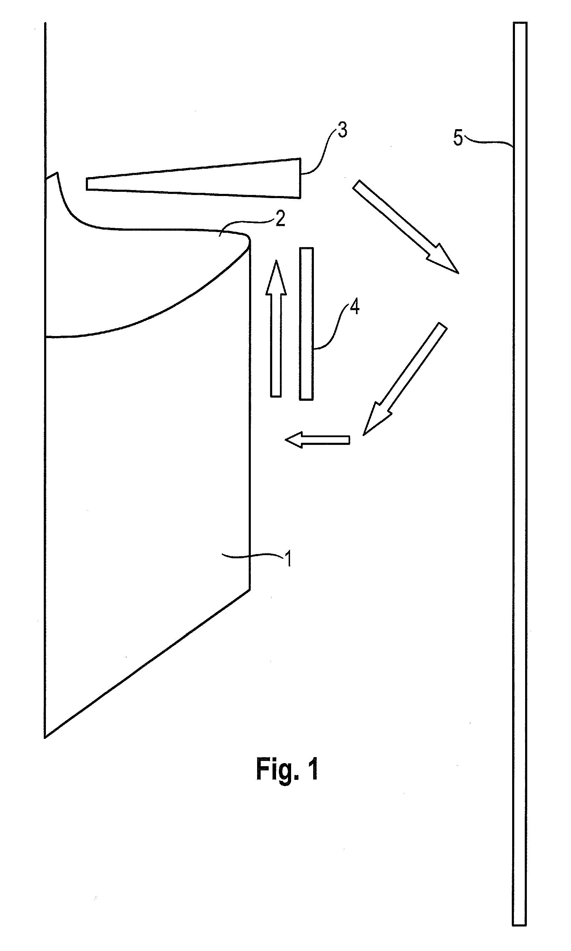

Fig.1 zeigt in Schnittdarstellung eine Vorrichtung zur Herstellung eines Einkristalls durch Kristallisieren des Einkristalls an einer Schmelzenzone. Diese Vorrichtung kann dem Stand der Technik zugerechnet werden. Dargestellt sind nur Merkmale, die zur Erläuterung der Erfindung beitragen. Der Einkristall 1 wächst an einer Schmelzenzone 2, die von einem Induktor 3 mit Wärme versorgt wird. Auf Höhe des Tripelpunktes ETP ist ein Reflektor 4 angeordnet, der den kristallisierenden Einkristall umgibt und eine axiale Länge hat, die kürzer ist als die Länge des hergestellten Einkristalls. Der Reflektor 4 teilt den Innenraum eines Gehäuses in einen Zwischenraum zwischen dem kristallisierenden Einkristall 1 und dem Reflektor 4 und einen Zwischenraum zwischen dem Reflektor 4 und der Wand 5 des Gehäuses. Blockpfeile deuten den geschlossenen Weg eines durch thermischen Auftrieb getriebenen Stroms eines im Gehäuse enthaltenen Schutzgases an.

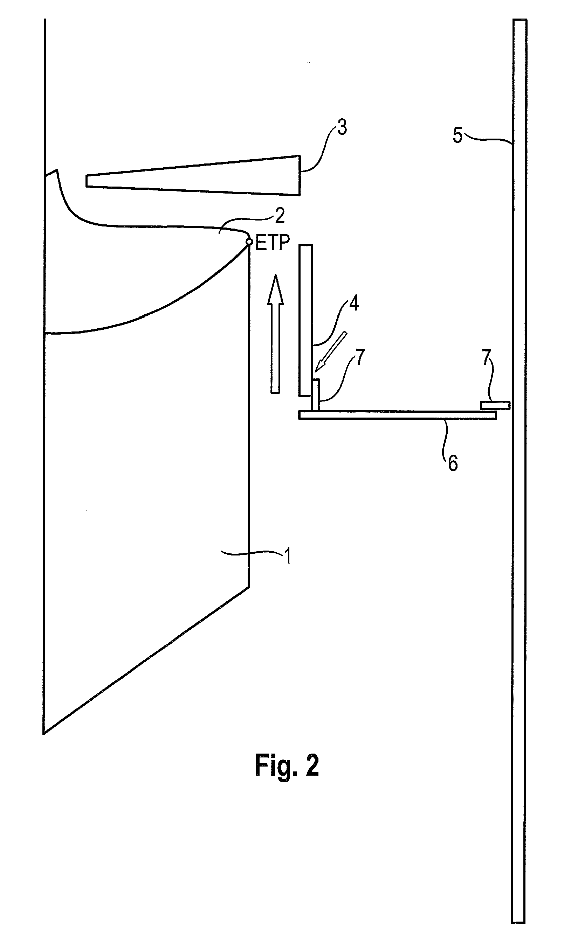

Fig.2 zeigt eine Vorrichtung gemäß Fig.1 und zusätzlich Merkmale der Erfindung. Gleichartige Merkmale sind mit denselben Bezugszahlen versehen. Die erfindungsgemäße Vorrichtung zeichnet sich durch einen Trennboden 6 aus, der den Zwischenraum zwischen dem Reflektor 4 und der Wand 5 des Gehäuses nach unten hin begrenzt. Der Reflektor 4 kann durch eine aktive Strahlungsheizung ersetzt sein. Im Vergleich mit Fig.1 dünner gezeichnete Blockpfeile zeigen einen durch thermischen Auftrieb getriebenen Gasstrom an, der wegen der Anordnung des Trennbodens 6 stark gehemmt ist. Der Gasstrom kann noch stärker bis hin zur vollständigen Blockade gehemmt sein, vorzugsweise indem Sperren 7 an äußeren Seiten des Trennbodens 6 angeordnet werden, die Spalte zwischen dem Reflektor 4 und dem Trennboden 6 und zwischen dem Trennboden 6 und der Wand 5 des Gehäuses verkürzen oder schließen.

## Patentansprüche

1. Vorrichtung zur Herstellung eines Einkristalls (1) durch Kristallisieren des Einkristalls (1) an einer Schmelzenzone (2), umfassend ein Gehäuse, einen Induktor (3) zum Erzeugen von Wärme in der Schmelzenzone (2), einen Nachheizer (4), der den unter der Schmelzenzone (2) kristallisierenden Einkristall (1) umgibt und mit Wärmestrahlung beaufschlagt, und einen Trennboden (6), der einen Zwischenraum zwischen dem Nachheizer (4) und einer Wand (5) des Gehäuses an einem unteren Ende des Nachheizers (4) nach unten hin begrenzt und strömendem Schutzgas als Barriere im Weg steht.

2. Vorrichtung nach Anspruch 1, **dadurch gekennzeichnet, dass** der Nachheizer (4) ein Reflektor ist.

3. Vorrichtung nach Anspruch 1, **dadurch gekennzeichnet, dass** der Nachheizer (4) eine aktive Strahlungsheizung ist.

4. Vorrichtung nach einem der Ansprüche 1 bis 3, **gekennzeichnet durch** Sperren (7), die an äußeren Seiten des Trennbodens (6) angeordnet sind und Spalte zwischen dem Nachheizer (4) und dem Trennboden (6) und zwischen dem Trennboden (6) und der Wand (5) des Gehäuses verkürzen oder schließen.

## Claims

1. Device for producing a single crystal (1) by crystallizing the single crystal (1) in a melt zone (2), comprising a housing, an inductor (3) for generating heat in the melt zone (2), a reheater (4) which surrounds and applies thermal radiation to the single crystal (1) crystallizing under the melt zone (2), and a separating bottom (6) which delimits an intermediate space between the reheater (4) and a wall (5) of the housing downward at a lower end of the reheater (4) and stands in the way of flowing protective gas as a barrier.

2. Device according to Claim 1, **characterized in that** the reheater (4) is a reflector.

3. Device according to Claim 1, **characterized in that** the reheater (4) is an active radiating heater.

4. Device according to one of Claims 1 to 3, **characterized by** barriers (7) which are arranged on outer sides of the separating bottom (6) and shorten or close gaps between the reheater (4) and the separating bottom (6) and between the separating bottom (6) and the wall (5) of the housing.

## Revendications

1. Dispositif pour la fabrication d'un monocristal (1) par cristallisation du monocristal (1) dans une zone de fusion (2) comprenant une enceinte, un inducteur (3) destiné à la production de chaleur dans la zone de fusion (2), un système de chauffage complémentaire (4) qui entoure et soumet à un rayonnement thermique le monocristal (1) qui cristallise sous la zone de fusion (2), et un plateau de séparation (6) qui délimite vers le bas une chambre intermédiaire entre le système de chauffage complémentaire (4) et une paroi (5) de l'enceinte à une extrémité inférieure du système de chauffage complémentaire (4) et fait barrière au gaz protecteur en circulation.

2. Dispositif selon la revendication 1, **caractérisé en ce que** le système de chauffage complémentaire (4) est un réflecteur.

3. Dispositif selon la revendication 1, **caractérisé en ce que** le système de chauffage complémentaire (4) est un chauffage par rayonnement.

4. Dispositif selon l'une quelconque des revendications 1 à 3, **caractérisé par** des éléments de blocage (7), qui sont disposés sur les côtés externes du plateau de séparation (6), et réduisent ou ferment les interstices entre le système de chauffage complémentaire (4) et le plateau de séparation (6) et entre le plateau de séparation (6) et la paroi (5) de l'enceinte.
